(19) **Europäisches Patentamt / European Patent Office / Office européen des brevets**

(11) **EP 3 227 697 B1**

(12) **EUROPEAN PATENT SPECIFICATION**

(45) Date of publication and mention
of the grant of the patent:
**01.04.2020 Bulletin 2020/14**

(21) Application number: **15866275.9**

(22) Date of filing: **01.12.2015**

(51) Int Cl.:
*G01R 31/08* (2020.01)       *H02H 3/00* (2006.01)
*H02J 3/18* (2006.01)       *H02H 3/42* (2006.01)
*H02H 7/28* (2006.01)

(86) International application number:
**PCT/US2015/063258**

(87) International publication number:
**WO 2016/089910 (09.06.2016 Gazette 2016/23)**

(54) **FAULT DETECTION AND DIRECTION DETERMINATION**

FEHLERDETEKTION UND RICHTUNGSBESTIMMUNG

DÉTECTION DE DÉFAUT ET DÉTERMINATION DE DIRECTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.12.2014 US 201462085961 P**

(43) Date of publication of application:
**11.10.2017 Bulletin 2017/41**

(73) Proprietor: **S & C Electric Co.
Chicago, IL 60626 (US)**

(72) Inventors:
• **ENNIS, Michael**
  **Chicago, Illinois 60626 (US)**
• **GARDNER, Adam**
  **Chicago, Illinois 60626 (US)**
• **MONTENEGRO, Alejandro**
  **Chicago, Illinois 60626 (US)**
• **SHARON, Yoav**
  **Chicago, Illinois 60626 (US)**

(74) Representative: **Barker Brettell LLP
100 Hagley Road
Edgbaston
Birmingham B16 8QQ (GB)**

(56) References cited:
**KR-A- 20140 056 964      US-A- 5 349 490
US-A- 5 764 044      US-A1- 2004 064 272
US-A1- 2007 285 857**

Printed by Jouve, 75001 PARIS (FR)

## Description

### CROSS-REFERENCE TO RELATED APPLICATIONS

This application claims the benefit of U.S. Provisional Application No. 62/085,961, filed on December 1, 2014 and US Application No. 14/956,125 filed on December 1, 2015.

### TECHNICAL FIELD

The present disclosure relates to electric power distribution systems, and more particularly, to an apparatus and method to determine a direction of the fault relative to a directional element upon occurrence of a fault within an electric power distribution system.

### BACKGROUND

This section provides background information related to the present disclosure, which is not necessarily prior art.

To determine fault direction, directional elements use the concept of torque. In digital relays the torque is computed with the current and voltage phasors, which are in turn calculated using discrete Fourier transform from the output signals of the current and potential transformers of the relay. There are six basic torques that are commonly used - a phase torque for each of the three phases, as well as the positive, negative, and zero sequence torques.

Directional elements are needed within electric power distribution systems to differentiate between load current and fault current when two or more sources are present in the distribution network. When a fault current is about two- or three-times the load current, this is easy to accomplish. But when the directional element is used in a relay that is protecting a distributed generation source, much lower fault current may need to be detected to identify the fault direction correctly. Moreover, certain limitations are recognized for individual phase torques with a particular torque angle, and of the positive sequence torque in general, particularly in distributed generation systems.

KR 2014 0056964 discloses a direction determination method for a directional property protection apparatus for power distribution lines. The directional property protection apparatus can perform a fault direction determination process regarding the directional property protection apparatus using a fault current in a distribution line connected with a distributed power source. The method includes: a first step in which the directional property protection apparatus determines whether one of the current value of an image current is twice as bigger than the current value of one of the three-phase-sequence currents or more when a failure occurs in the distribution line connected with the distributed power source; and a second step in which the occurrence of a failure current in a reverse direction is determined when the directional property protection apparatus determines one of the current value of an image current is twice as bigger than the current value of one of the three-phase-sequence currents or more, or the occurrence of a failure current in a forward direction is determined when the directional property protection apparatus determines one of the current value of an image current is less than the twice of the current value of one of the three-phase-sequence currents.

US 5349490 discloses a directional element, which measures the negative sequence voltage and the negative sequence current and from those quantities produces a scalar quantity related to the negative sequence impedance of a power transmission line relative to the location of the directional element. The scalar quantity is then compared against two threshold quantity settings, one to determine a forward fault, the other to determine a reverse fault. The scalar quantity must be less than the forward threshold quantity for a forward fault and greater than the reverse threshold quantity for a reverse fault.

Accordingly, it is desirable to provide fault detection and fault direction determination with a phase overcurrent relay using individual phase torques and the negative sequence torque, and with a ground overcurrent relay using the zero sequence torque. It is also desirable to provide a device utilizing minimum pickup thresholds that will assure correct operation of the directional elements. Furthermore, other desirable features and characteristics of the present invention will become apparent from the subsequent detailed description of the invention and the appended claims, taken in conjunction with the accompanying drawings and this background of the invention.

### BRIEF DESCRIPTION OF THE DRAWINGS

The drawings described herein are for illustrative purposes only of selected embodiments and not all possible implementations, and are not intended to limit the scope of the present disclosure.

FIG. 1 shows a schematic representation of an electric power distribution system having multiple power sources;

FIG.2 is a process diagram representing a work flow for fault detection and direction determination in accordance with the present disclosure;

FIG.3 is a flow chart showing the ground element logic algorithm and the negative element logic algorithm. executed by the directional element for fault detection and direction determination; and

FIG.4 is a flow chart showing a phase element logic algorithm executed by the directional element for fault detection and direction determination.

Corresponding reference numerals indicate corresponding parts throughout the several views of the drawings.

DETAILED DESCRIPTION

In accordance with the present disclosure, fault detection and fault direction determination is achieved with a phase overcurrent relay using individual phase torques and the negative sequence torque, and with a ground overcurrent relay using the zero sequence torque. Also disclosed is a device utilizing minimum pickup thresholds that will assure correct operation of the directional element.

The directional element can be installed at any point on a three-phase distribution network line. Using real-time three-phase voltage and current measurements, and few inputs supplied by the protection engineer, the device can identify if a fault occurred, and if yes, the direction to the fault from the installation point. It may be used with other devices such as relays, switches and fault interrupters in order to assist with fault protection, isolation and automatic system restoration.

Improvement over similar available devices is realized in the need for very minimal manual setup, the ability to detect direction to faults where fault current is only slightly higher than load current, and the ability to detect direction to faults in systems with more than one source. Finally, the device can also distinguish between real signal originating from the electric network, and phantom signal due to noise in the sensors system.

While conventional directional elements can use different torques (phase torques, positive sequence torque, zero sequence torque, negative sequence torque) to determine the direction to the fault, at least some of these torques may not indicate the direction of the fault in many instances due to the presence of load and/or measurement noise in the system. The improvements listed above are achieved by in a directional element that automatically selects in real-time which torque should be used. In addition, the directional element uses individual phase torques to achieve higher sensitivity.

As described, a directional element and method may detect a fault and determine its direction using negative sequence torque when the negative sequence voltage is high enough. Zero sequence torque may be used when both zero sequence current and voltage are strong enough. Otherwise, one or more individual phase torques may be used depending on voltage level and pickup threshold. Otherwise, a summation of the phase torques is used. An improvement of the described directional element and method is therefore the ability to detect fault on one side of the distribution network while large load exists on the other side of the distribution network. This is accomplished by the introduction of the individual phase torque to determine the direction. Additional modifications may be implemented to ensure that this improvement does not adversely affect the performance of the directional element.

A method of fault detection and direction determination is provided for a three-phase electric power distribution system having a gird including a first source on a first side of the grid and a second source on the second side of the grid. Initially, the current and voltage for each of the three power phases is measured at a location between the first and second side to determine an operational state of the electric power distribution system. The operational state is first evaluated using a ground element logic algorithm. A first fault condition in a direction of side X is indicated when a magnitude for a ground current is greater than an overcurrent ground threshold value for side X. A second fault condition in a direction of side Y is indicated when the magnitude for the ground current is greater than the overcurrent ground threshold value for side Y. A no fault condition is indicated when neither the first or second fault condition is indicated. The operational state is next evaluated using a negative element logic algorithm. The first fault condition is indicated when the magnitude for a negative sequence current is greater than an overcurrent negative threshold value for side. The second fault condition is indicated when the magnitude for the negative sequence current is greater than an overcurrent negative threshold value for side Y. The no fault condition is again indicated when neither the first or second fault condition is indicated.

Lastly, the operation state is evaluated using a phase element logic algorithm with a two-step approach - first, based on the maximum value of the magnitude for any of the phasor value currents, then second based on the torque for each of the phases. With the first step, the first fault is indicated when a maximum value of the magnitude of a phasor current for any of the three phases is greater than an overcurrent phase threshold value for side X. The second fault is indicated when the maximum value of the magnitude the phasor current for any of the three phases is greater than an overcurrent phase threshold value for side Y. When neither the first or second fault condition is indicated from the first step, the phase element logic algorithm evaluates the torque for each of the phases to detect a fault condition and determine the direction of the fault condition. A fault in the direction of side X may be indicated when the summation of the sequence torques values is less than zero or when the maximum value of the magnitude for any of the phasor currents is greater than the overcurrent phase threshold value for side X and the maximum value of any sequence torque value is less than or equal to zero. A fault in the direction of side Y may be indicated when the summation of the sequence torques values is equal to or greater than zero or when the maximum value of the magnitude for any of the phasor currents is greater than the overcurrent phase threshold value for side Y and the minimum value of any sequence torque value is equal to or greater than zero. If none of these conditions are satisfied, then a no fault condition is indicated.

A directional element is also provided for fault detection and direction determination in a three-phase electric power distribution system including a gird having a first source on an first side of the grid and a second source on the second side of the grid. The directional element is operable to evaluate the operational state of the electric power distribution system using a logic algorithm which establishes precedence between the ground, negative and phase elements for fault detection and direction determination. The directional element includes a ground element logic circuit configured to indicate a first fault condition in a direction of side X when a magnitude for a ground current is greater than an overcurrent ground threshold value for side X, a second fault condition in a direction of side Y when the magnitude for the ground current is greater than the overcurrent ground threshold value for side Y, and a no fault condition when neither the first or second fault condition is indicated. The directional element also includes a negative element logic circuit configured to indicate the first fault when the magnitude for a negative sequence current is greater than an overcurrent negative threshold value for side, the second fault condition when the magnitude for the negative sequence current is greater than an overcurrent negative threshold value for side Y, and the no fault condition when neither the first or second fault condition is indicated.

The directional element further includes a phase element logic circuit to detect the fault condition and determine the direction with a two-step approach - first, based on the maximum value of the magnitude for any of the phasor value currents, then second based on the torque for each of the phases. Initially with the first step, the phase element logic circuit indicate the first fault when a maximum value of the magnitude of a phasor current for any of the three phases is greater than an overcurrent phase threshold value for side X, the second fault when the maximum value of the magnitude the phasor current for any of the three phases is greater than an overcurrent phase threshold value for side Y. When neither the first or second fault condition is indicated from the first step, the phase element logic algorithm evaluates the torque for each of the phases to detect a fault condition and determine the direction of the fault condition. A fault in the direction of side X may be indicated when the summation of the sequence torques values is less than zero or when the maximum value of the magnitude for any of the phasor currents is greater than the overcurrent phase threshold value for side X and the maximum value of any sequence torque value is less than or equal to zero. A fault in the direction of side Y may be indicated when the summation of the sequence torques values is equal to or greater than zero or when the maximum value of the magnitude for any of the phasor currents is greater than the overcurrent phase threshold value for side Y and the minimum value of any sequence torque value is equal to or greater than zero. If none of these conditions are satisfied, then a no fault condition is indicated.

Example embodiments will now be described more fully with reference to the accompanying drawings. There is no intention to be limited by any principle presented in the preceding background or the following detailed description.

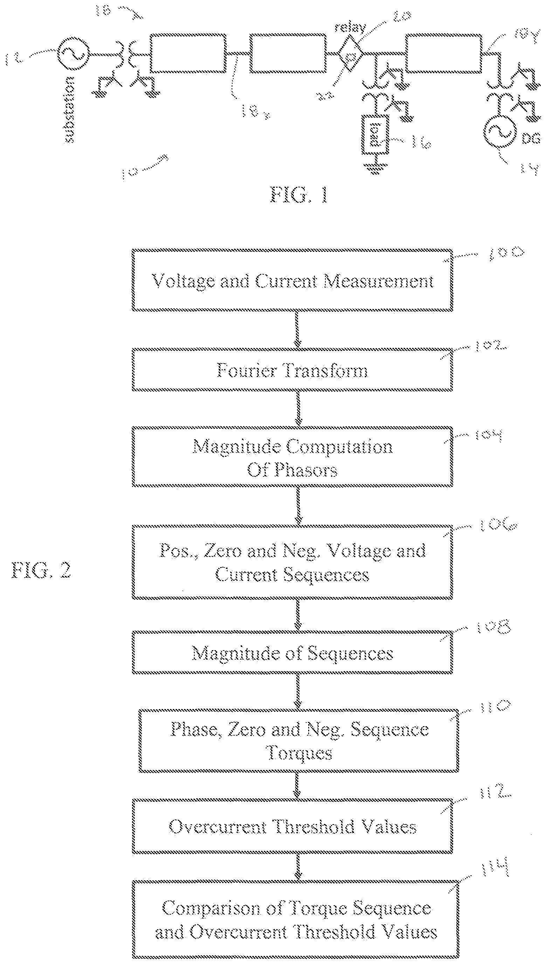

With reference now to FIG. 1, an electric power distribution system 10 is shown to include multiple sources 12, 14 and a load 16 residing on a power distribution network or grid 18. In this configuration, source 12 represents a substation on a first side 18x (side X) of the electric power distribution system 10, and source 14 represent a distributed generator or DG on a second side 18y (side Y) of the electric power distribution system 10. These sources 12, 14 provide three-phase power (A, B, C) to the load 16 through the electric power distribution system 10. The electrical power distribution system 10 further includes one or more switching devices or relays 20 having distributed intelligence for implementing real-time grid control to increase power distribution reliability from the sources 12, 14 over the grid 18 based on the operating conditions at the relay 20. With distributed intelligence, the relay 20 installed on the power grid may implement embedded controls to monitor local conditions. They also communicate with other relays or switches to get data on system conditions at other adjacent devices.

One form of distributed intelligence includes a directional element 22, which operates to detect the occurrence of a fault within an electric power distribution system 10 and determine a direction of the fault relative to the directional element 22. In particular, the directional element 22 analyzes data concerning the operational state of the grid 18 in real time to quickly determine the occurrence and direction of the fault. With this information the relay 20 may determine whether the relay 20 should operate to rapidly reconfigure the electrical power system 10 and restore power to the load 16.

To determine fault direction, the directional element 22 uses the concept of torque. In a digital relay 20, torque may be computed with the current and voltage phasors, which are in turn calculated using discrete Fourier transform from the output signals of the current and potential transformers of the relay 20. With reference now to FIG. 2, the directional element 22 is provided with measurement signals at block 100 representing the current and voltage for each of the three power phases (A, B, C) at the relay 20. A Fourier transform at the system frequency is applied to the three current and three voltage measurements at block 102 resulting in six complex (phasor) values: $i_A$, $i_B$, $i_C$, $v_A$, $v_B$, $v_C$. The magnitude (absolute value) for each of the six phasors $I_A$, $I_B$, $I_C$, $V_A$, $V_B$, $V_C$ is computed at block 104. From the phasor values the positive, zero and negative sequence current and voltage, $i_0$, $i_1$, $i_2$, $v_0$, $v_1$, $v_2$, are computed at block 106, and the magnitude thereof $I_0$, $I_1$, $I_2$, $V_0$, $V_1$, $V_2$ are computed at block 108. With these computation complete, the phase sequence torques ($T_A$, $T_B$, $T_C$) zero sequence torque ($T_{zero}$) and negative sequence torque ($T_{neg}$) are then computed as a function of the phasor values and a maximum torque angle (MTA) at block 110 according to the following equations:

$$T_{A_n} = \mathrm{Re}\left(e^{-j \cdot MTA_{ph}} \cdot (v_A - v_0) \cdot i_A^*\right)$$

$$T_{B_n} = \mathrm{Re}\left(e^{-j \cdot MTA_{ph}} \cdot (v_B - v_0) \cdot i_B^*\right)$$

$$T_{C_n} = \mathrm{Re}\left(e^{-j \cdot MTA_{ph}} \cdot (v_C - v_0) \cdot i_C^*\right)$$

$$T_{Amin_n} = \mathrm{Re}\left(e^{-j \cdot MTA_{min}} \cdot (v_A - v_0) \cdot i_A^*\right)$$

$$T_{Bmin_n} = \mathrm{Re}\left(e^{-j \cdot MTA_{min}} \cdot (v_B - v_0) \cdot i_B^*\right)$$

$$T_{Cmin_n} = \mathrm{Re}\left(e^{-j \cdot MTA_{min}} \cdot (v_C - v_0) \cdot i_C^*\right)$$

$$T_{Amax_n} = \mathrm{Re}\left(e^{-j \cdot MTA_{max}} \cdot (v_A - v_0) \cdot i_A^*\right)$$

$$T_{Bmax_n} = \mathrm{Re}\left(e^{-j \cdot MTA_{max}} \cdot (v_B - v_0) \cdot i_B^*\right)$$

$$T_{Cmax_n} = \mathrm{Re}\left(e^{-j \cdot MTA_{max}} \cdot (v_C - v_0) \cdot i_C^*\right)$$

$$T_{neg_n} = -\mathrm{Re}\left(e^{j \cdot MTA_{neg}} \cdot v_2 \cdot i_2^*\right)$$

$$T_{zero_n} = -\mathrm{Re}\left(e^{j \cdot MTA_{zero}} \cdot v_0 \cdot i_0^*\right)$$

From the equations set forth above, it becomes apparent that the zero sequence voltage $v_0$ is subtracted from the complex values $v_a$, $v_b$, $v_c$ before computing the phase torques $T_A$, $T_B$, $T_C$.

Overcurrent threshold values for the phase sequence, ground or residual sequence and negative sequence may be defined as $\tau_{ph}^X$, $\tau_g^X$, $\tau_n^X$ for one side (side X) and $\tau_{ph}^Y$, $\tau_g^Y$, $\tau_n^Y$, for the other side (side Y) at block 112. If any one of the overcurrent threshold values is not defined, a default value may be set to infinity. The sides X and Y are defined such that the phasor of a phase current originating from a source on X to serve a purely resistive load on Y will have the same angle as the phase voltage phasor. A nominal line to ground voltage (RMS) may also be defined as $V_n$ at block 112.

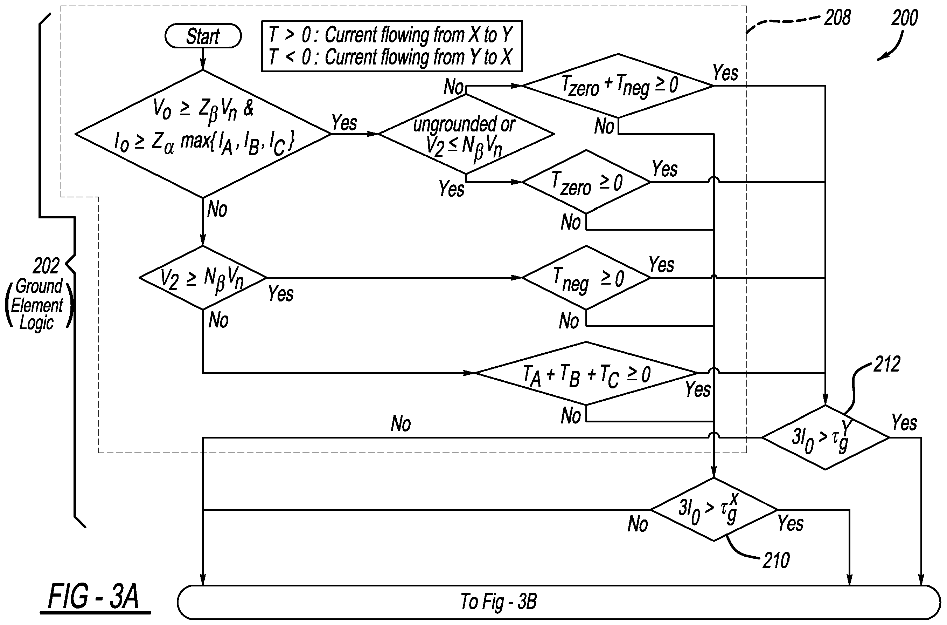

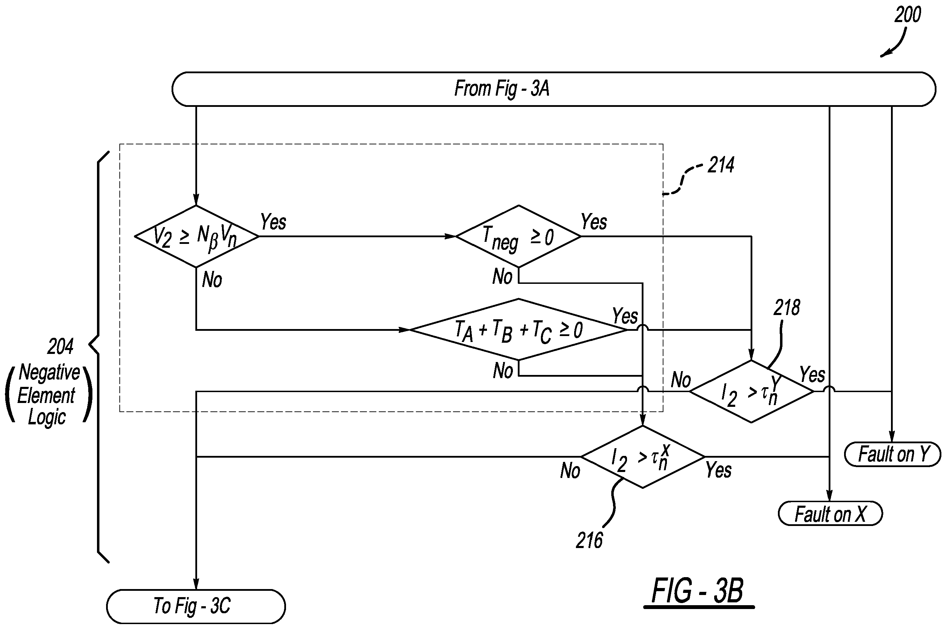

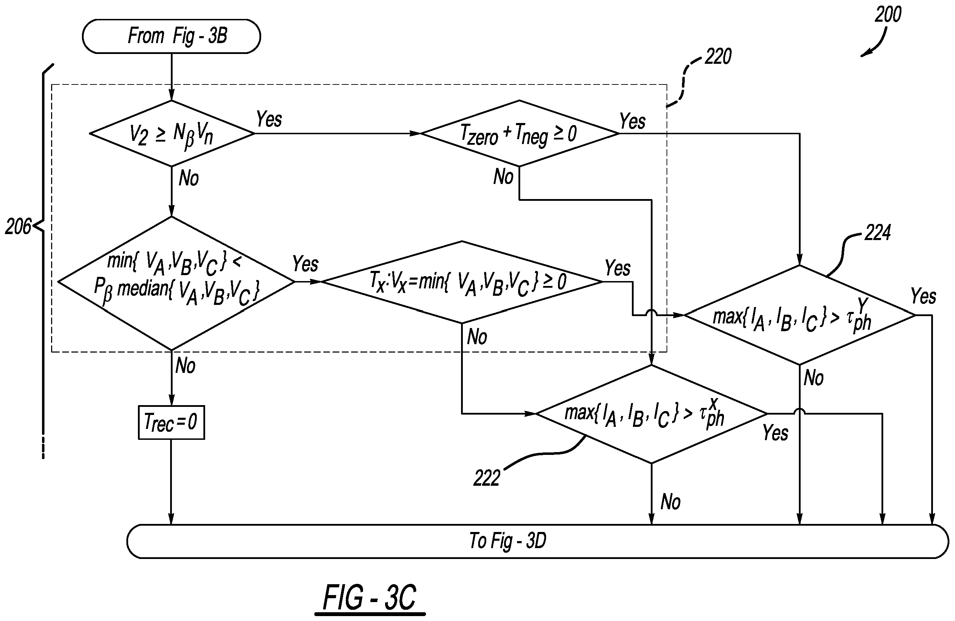

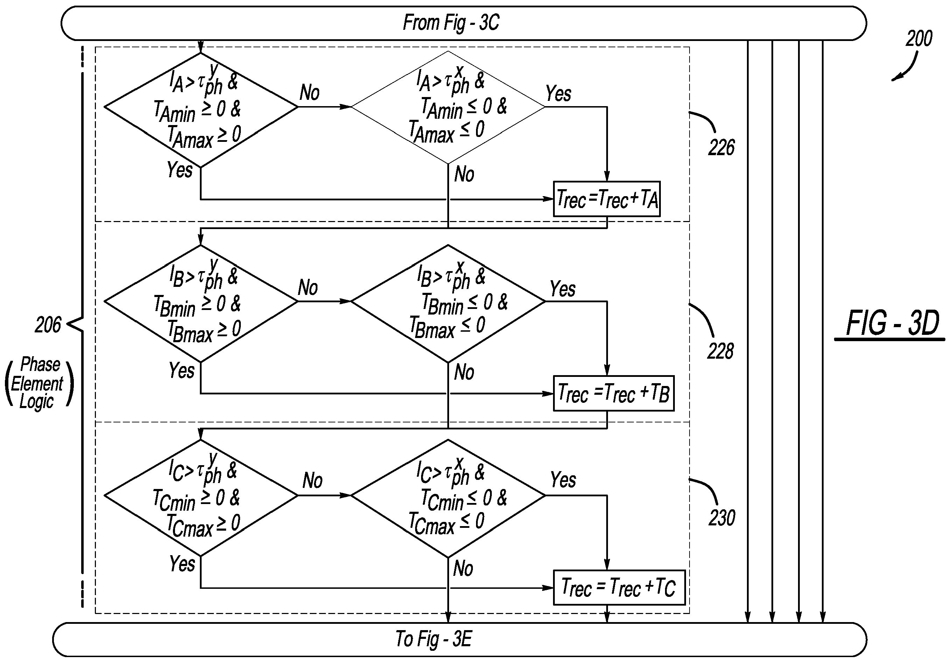

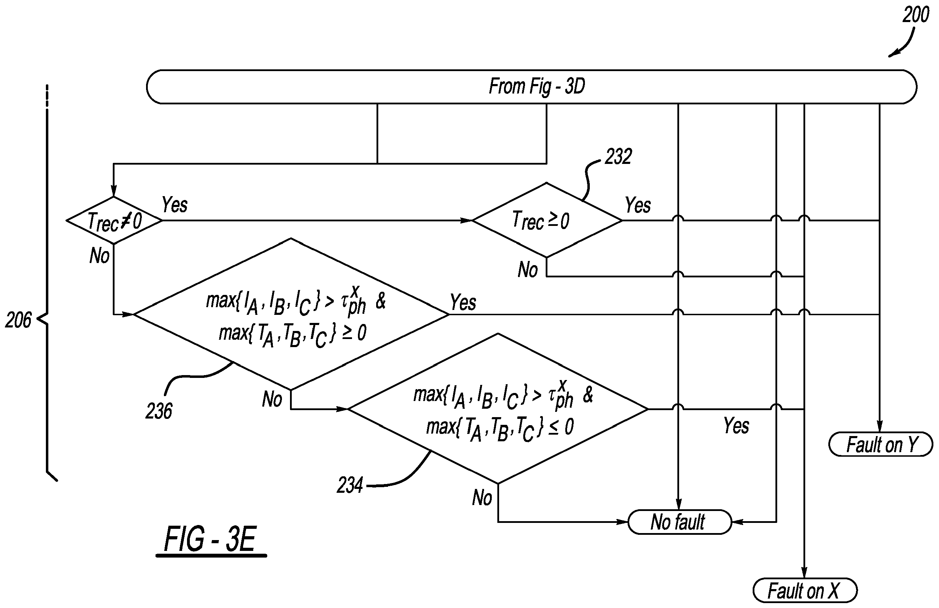

Using these values, the directional element 22 compares the torque sequence values and the overcurrent threshold values at block 114 in accordance with the logic algorithm 200 depicted in FIGS. 3 and 4 to determine the occurrence and direction of a fault within the electric power distribution system 10, wherein T>0 represent current flowing in a direction from side X to side Y, whereas T<0 represent current flowing in a direction from side Y to side X. Based on the operational state of the electric power generation system 10, logic algorithm 200 defines precedence between the ground, negative and phase elements to implement a staged evaluation for fault detection and direction determination based on an automatically selecting of the torque to be used. In particular, logic algorithm 200 includes a ground element logic circuit 202, a negative element logic circuit 204 and a phase element logic circuit 206 for detecting a fault in the direction of side X or in the direction of side Y.

With reference now to FIG. 3, after querying the operational state of the electric power generation system 10, the ground element logic circuit 202 evaluates the phase sequence torques ($T_A$, $T_B$, $T_C$), zero sequence torque ($T_{zero}$) and negative sequence torque ($T_{neg}$) as indicated at block 208 to determine the direction of a potential fault. For example, a potential fault may exist on side X when ($T_{zero} + T_{neg}$) or ($T_{zero}$) or ($T_{neg}$) or ($T_A + T_B + T_C$) < 0. Conversely, a potential fault may exist on side Y when ($T_{zero} + T_{neg}$) or ($T_{zero}$) or ($T_{neg}$) or ($T_A + T_B + T_C$) ≥ 0. Once the direction of a potential fault is determine, the ground element logic circuit 202 is configured to indicate a fault condition in the direction of side X when a multiple of the magnitude for the ground current ($3I_0$) is greater than the overcurrent ground threshold value for side X $\left(\tau_g^x\right)$ at block 210. Similarly, a fault condition in the direction of side Y is indicated when a multiple of the magnitude for the ground current ($3I_0$) is greater than the overcurrent ground threshold value for side Y $\left(\tau_g^y\right)$ at block 212. If a fault is not detected in accordance with the ground element logic circuit 202, logic algorithm 200 proceeds to the negative element logic circuit 204.

The negative element logic circuit 204 again queries the operational state of the electric power generation system 10, then evaluates the phase sequence torques ($T_A$, $T_B$, $T_C$) and the negative sequence torque ($T_{neg}$) at block 214 to determine the direction of a potential fault. For example, a potential fault may exist on side X when ($T_{neg}$) or ($T_A + T_B + T_C$) < 0. Conversely, a potential fault may exist on side Y when ($T_{neg}$) or ($T_A + T_B + T_C$) ≥ 0. Once the direction of a potential fault is determine, the negative element logic circuit 204 is configured to indicate a fault condition in the direction of side X when the magnitude for the negative sequence current ($I_2$) is greater than the overcurrent negative threshold value for side X $\left(\tau_n^x\right)$ at block 216. Similarly, a fault in the direction of side Y is detected when the magnitude for the negative sequence current ($I_2$) is greater than the overcurrent negative threshold value for side Y $\left(\tau_n^y\right)$ at block 218. If a fault condition is not detected in accordance with the negative element logic circuit 202, logic algorithm 200 proceeds to the phase element logic circuit 204 as shown in FIG. 4.

With reference now to FIG. 4, the phase element logic circuit 206 again queries the operational state of the electric power generation system 10, then evaluates the phase sequence torques ($T_A$, $T_B$, $T_C$) and the negative sequence torque ($T_{neg}$) at block 220 to determine the direction of a potential fault. For example, a potential fault may exist on side X when ($T_{zero} + T_{neg}$) or ($T_{x:Vx} = min(V_A, V_B, V_C)$) < 0. Conversely, a potential fault may exist on side Y when ($T_{zero} + T_{neg}$) or ($T_{x:Vx} = min(V_A, V_B, V_C)$) ≥ 0. Once the direction of a potential fault is determine, the phase element logic circuit 206 evaluates the fault condition based on a maximum current for all of the phases. Specifically, the phase element logic circuit 206 will indicate a fault condition in the direction of side X when the maximum value of the magnitude for any of the phasor currents ($max(I_A, I_B, I_C)$) is greater than the overcurrent phase threshold value for side X $\left(\tau_{ph}^x\right)$ at block 222. Similarly, a fault condition in the direction of side Y is indicated when the maximum value of the magnitude for any of the phasor value currents ($max(I_A, I_B, I_C)$) is greater than the overcurrent phase threshold value for side Y $\left(\tau_{ph}^y\right)$ at block 224.

If a fault condition is not detected based on the maximum value of the magnitude for any of the phasor value currents, phase element logic circuit 206 proceeds to evaluate the phase sequence torques ($T_A$, $T_B$, $T_C$) based on each of the phasor currents at blocks 226, 228, 230. For example, in block 226 a potential fault may exist on side X when ($T_{Amin}$) or ($T_{Amax}$) < 0 and when the magnitude of the phasor currents ($I_A$) is greater than the overcurrent phase threshold value for side X $\left(\tau_{ph}^x\right)$. Conversely, a potential fault may exist on side Y when ($T_{Amin}$) or ($T_{Amax}$) ≥ 0 and when the magnitude of the phasor currents ($I_A$) is greater than the overcurrent phase threshold value for side Y $\left(\tau_{ph}^y\right)$. The evaluation in blocks 228, 230 is essentially as executed in block 226 except that it is carried out on a different phase, and thus need not be further described herein.

A fault condition in the direction of side X may be indicated when the summation of the sequence torques values ($T_A$, $T_B$, $T_C$) is less than zero as indicated at block 232 or when the maximum value of the magnitude for any of the phasor currents ($max(I_A, I_B, I_C)$) is greater than the overcurrent phase threshold value for side X $\left(\tau_{ph}^x\right)$ and the maximum value of any sequence torque value ($max(T_A, T_B, T_C)$) is less than or equal to zero as indicated at block 234. Similarly, a fault condition in the direction of side Y may be indicated when the summation of the sequence torques values ($T_A$, $T_B$, $T_C$) is equal to or greater than zero as indicated at block 232 or when the maximum value of the magnitude for any of the phasor currents ($max(I_A, I_B, I_C)$) is greater than the overcurrent phase threshold value for side Y $\left(\tau_{ph}^y\right)$ and the minimum value of any sequence torque value ($min(T_A, T_B, T_C)$) is equal to or greater than zero as indicated at block 236. If none of these conditions are satisfied, then a fault condition has not been detected.

From the present disclosure, one skilled in the art will appreciate that implementation of logic algorithm 200 in the directional element 22 provides several distinct advantages over conventional fault detection and direction determination algorithms. For example, forward and reverse direction of phase torques are defined by restricted slices controlled by $MTA_{min}$ and $MTA_{max}$. From FIGS. 3 and 4, it is clear that logic algorithm 200 establishes precedence between the ground, negative and phase elements for fault detection and direction determination. As represented in FIG. 3, logic algorithm 200 only uses the sequence torques to detect fault and determine direction when the signal-to noise ratio of sequence voltage and current is high enough as controlled by $Z_\alpha$, $Z_\beta$ and determined by the sensor noise level. As shown in FIG. 4, phase element logic circuit 206 allows a single phase torque to determine the direction of a fault under certain conditions. As shown in FIG. 4, when a phase voltage is significantly lower than other phase voltages, phase element logic circuit 206 uses the phase torque of the phase with the lowest voltage to determine the fault direction. Phase element logic circuit 206 also enables the use of the negative sequence to choose whether the negative sequence torque or the phase torque determined the fault direction as shown in FIG. 4.

The foregoing description of the embodiments has been provided for purposes of illustration and description. It is not intended to be exhaustive or to limit the disclosure. Individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

## Claims

1. A method of fault detection and direction determination in a three-phase electric power distribution system (10) including a grid having a first source (12) on an first side (18x) of the grid and a second source (14) on the second side (18y) of the grid, the method comprising:

   measuring a current and voltage for each of the three power phases at a location between the first and second side (18x, 18y) to determine an operational state of the electric power distribution system (10) including a zero sequence torque, a ground current, a negative sequence torque, a negative sequence current, and a phase torque and a phasor current for each of the three phase;
   evaluating the operational state using a ground element logic algorithm (202) to indicate a first fault condition in a direction of the first side (18x) when at least one of the zero torque sequence, the negative sequence torque or a sum of the phase torques is less than zero and a magnitude for the ground current is greater than an overcurrent ground threshold value for the first side (18x), a second fault condition in a direction of the second side (18y) when at least one of the zero torque sequence, the negative sequence torque or the sum of the phase torques is greater than zero and the magnitude for the ground current is greater than the overcurrent ground threshold value for the second side (18y), and a no fault condition when neither the first or second fault condition is indicated;
   evaluating the operational state using a negative element logic algorithm (204) to indicate the first fault condition when the negative sequence torque is less than zero and the magnitude for the negative sequence current is greater than an overcurrent negative threshold value for the first side (18x), the second fault condition when the negative sequence torque is greater than zero and the magnitude for the negative sequence current is greater than an overcurrent negative threshold value for the second side (18y), and the no fault condition when neither the first or second fault condition is indicated; and
   evaluating the operation state using a phase element logic algorithm (206) to indicate the first fault condition when any of the three phase torques are less than zero and a maximum value of the magnitude of the phasor current for any one of the three phases is greater than an overcurrent phase threshold value for the first side (18x), the second fault condition when any one of the phase torques are greater than zero and the maximum value of the magnitude the phasor current for any one of the three phases is greater than an overcurrent phase threshold value for the second side (18y), and the no fault condition when neither the first or second fault condition is indicated.

2. The method of fault detection and direction determination according to claim 1 further comprises evaluating the operation state using the phase element logic algorithm (206) to indicate the first fault condition when a summation of the phase torques for each of the phases is less than zero or when the maximum value of the magnitude for any one of the three phasor currents is greater than the overcurrent phase threshold value for the first side (18x) and a maximum value of any phase torque value is less than or equal to zero.

3. The method of fault detection and direction determination according to claim 2 further comprises evaluating the operation state using the phase element logic algorithm (206) to indicate the second fault condition when the summation of the phase torques for each of the phases is equal to or greater than zero or when the maximum value of the magnitude for any one of the three phasor currents is greater than a overcurrent phase threshold value for the second side (18y) and a minimum value of any phase torque value is equal to or greater than zero.

4. A directional element (22) for fault detection and direction determination in a three-phase electric power distribution system (10) including a grid having a first source on a first side (18x) of the grid and a second source on a second side (18y) of the grid, the directional element for evaluating the operational state of the electric power distribution system (10) and comprising:

   a sensor element configured to measure current and voltage for each of the three power phases at a location between the first and second side (18x, 18y) and determine an operational state of the electric power distribution system (10) including a zero sequence torque, a ground current, a negative sequence torque, a negative sequence current, and a phase torque and a phasor current for each of the three phases;
   a ground element logic circuit (202) configured to indicate a first fault condition in a direction of the first side (18x) when at least one of the zero sequence torque, the negative sequence torque or a sum of the phase torques is less than zero and a magnitude for the ground sequence current is greater than an overcurrent ground threshold value for the first side (18x), a second fault condition in a direction of the second side (18y) when at least one of the zero sequence torque, the negative sequence torque, or a sum of the phase torques is greater than zero and the magnitude for the ground current is greater than the overcurrent ground threshold value for the second side (18y), and a no fault condition when neither the first or second fault condition is indicated;

a negative element logic circuit (204) configured to indicate the first fault condition when the negative sequence torque is less than zero and the magnitude for the negative sequence current is greater than an overcurrent negative threshold value for the first side (18x), the second fault condition when the negative sequence torque is greater than zero and the magnitude for the negative sequence current is greater than an overcurrent negative threshold value for the second side (18y), and the no fault condition when neither the first or second fault condition is indicated; and

a phase element logic circuit (206) to indicate the first fault condition when any one of the three phase torques is less than zero and a maximum value of the magnitude of the phasor current for any one of the three phases is greater than an overcurrent phase threshold value for the first side (18x), the second fault condition when any one of the three phase torques is greater than zero and the maximum value of the magnitude the phasor current for any one of the three phases is greater than an overcurrent phase threshold value for the second side (18y), and the no fault condition when neither the first or second fault condition is indicated.

5. The directional element according to claim 4, wherein the phase element logic circuit (206) is further configured to indicate the first fault condition when a summation of the phase torques for each of the phases is less than zero or when the maximum value of the magnitude for any one of the three phasor currents is greater than the overcurrent phase threshold value for the first side (18x) and a maximum value of any phase torque is less than or equal to zero.

6. The directional element according to claim 5, wherein the phase element logic circuit (206) is further configured to indicate the second fault condition when the summation of the phase torques is equal to or greater than zero or when the maximum value of the magnitude for any one of the three phasor currents is greater than a overcurrent phase threshold value for the second side (18y) and the minimum value of any phase torque is equal to or greater than zero.

**Patentansprüche**

1. Verfahren zur Fehlererkennung und Richtungsbestimmung in einem dreiphasigen elektrischen Energieverteilungssystem (10) mit einem Netz, das eine erste Quelle (12) auf einer ersten Seite (18x) des Netzes und eine zweite Quelle (14) auf der zweiten Seite (18y) des Netzes aufweist, wobei das Verfahren umfasst:

Messen eines Stroms und einer Spannung für jede der drei Leistungsphasen an einer Stelle zwischen der ersten und der zweiten Seite (18x, 18y), um einen Betriebszustand des elektrischen Energieverteilungssystems (10) zu bestimmen, der ein Nulldrehmoment, einen Massenstrom, ein Gegendrehmoment, einen Gegenstrom und ein Phasendrehmoment und einen Phasorstrom für jede der drei Phasen umfasst;

Bewerten des Betriebszustands unter Verwendung eines Masseelement-Logikalgorithmus (202), um einen ersten Fehlerzustand in einer Richtung der ersten Seite (18x) anzuzeigen, wenn mindestens eines das Nulldrehmoment, das Gegendrehmoment oder eine Summe der Phasendrehmomente kleiner als Null ist und eine Größe für den Massenstrom größer als ein Masse-Überstrom-Grenzwert für die erste Seite (18x) ist, eine zweite Fehlerbedingung in einer Richtung der zweiten Seite (18y), wenn mindestens eines das Nulldrehmoment, das Gegendrehmoment oder die Summe der Phasendrehmomente größer als Null ist und die Größe für den Massestrom größer als der Masse-Überstrom-Grenzwert für die zweite Seite (18y) ist, und eine Nicht-Fehlerbedingung, wenn weder die erste noch die zweite Fehlerbedingung angezeigt wird;

Bewerten des Betriebszustands unter Verwendung eines Negativelementlogik-Algorithmus (204), um den ersten Fehlerzustand, wenn das Gegenstromdrehmoment kleiner als Null ist und die Größe für den Gegenstrom größer als ein negativer Überstrom-Grenzwert für die erste Seite (18x) ist anzuzeigen, die zweite Fehlerbedingung, wenn das Gegenstromdrehmoment größer als Null ist und die Größe des Gegenstroms größer als ein negativer Überstrom-Grenzwert für die zweite Seite (18y) ist, und eine Null-Fehlerbedingung angezeigt wird, wenn weder die erste noch die zweite Fehlerbedingung gegeben ist; und

Auswerten des Betriebszustands unter Verwendung eines Phasenelementlogik-Algorithmus (206), um den ersten Fehlerzustand anzuzeigen, wenn eines der Dreiphasen-Drehmomente kleiner als Null ist und ein Maximalwert der Größe des Phasorstroms für eine der drei Phasen größer als ein Überstrom-Phasenschwellenwert für die erste Seite (18x) ist, die zweite Fehlerbedingung, wenn eines der Phasendrehmomente größer als Null ist und der Maximalwert der Größe des Phasorstroms für eine der drei Phasen größer als ein Überstrom-Phasenschwellwert für die zweite Seite (18y) ist, und eine Null-Fehlerbedingung angezeigt wird, wenn weder die erste noch die zweite Fehlerbedingung gegeben ist.

2. Verfahren zur Fehlererkennung und Richtungsbestimmung nach Anspruch 1 umfasst ferner die Auswertung des Betriebszustandes unter Verwendung des Phasenelementlogik-Algorithmus (206), um den ersten Fehlerzustand, wenn eine Summe der Phasendrehmomente für jede der Phasen kleiner als Null ist oder wenn der Maximalwert der Größe für irgendeinen der drei Phasorströme größer als der Überstromphasengrenzwert für die erste Seite (18x) und ein Maximalwert irgendeines Phasendrehmoments kleiner oder gleich Null ist, anzuzeigen.

3. Verfahren zur Fehlererkennung und Richtungsbestimmung nach Anspruch 2 umfasst ferner, die Auswertung des Betriebszustandes unter Verwendung des Phasenelementlogik-Algorithmus (206), um den zweiten Fehlerzustand anzuzeigen, wenn die Summe der Phasendrehmomente für jede der Phasen gleich oder größer als Null ist oder wenn der Maximalwert der Größe für irgendeinen der drei Phasorströme größer als ein Überstromphasengrenzwert für die zweite Seite (18y) und ein Minimalwert irgendeines Phasendrehmomentwertes gleich oder größer als Null ist.

4. Richtungselement (22) zur Fehlererkennung und Richtungsbestimmung in einem dreiphasigen elektrischen Energieverteilungssystem (10) mit einem Netz, das eine erste Quelle auf einer ersten Seite (18x) des Netzes und eine zweite Quelle auf einer zweiten Seite (18y) des Netzes enthält, wobei das Richtungselement zur Bewertung des Betriebszustands des elektrischen Energieverteilungssystems (10) umfasst:

Ein Sensorelement, welches konfiguriert ist, um Strom und Spannung für jede der drei Leistungsphasen an einer Stelle zwischen der ersten und der zweiten Seite (18x, 18y) zu messen und einen Betriebszustand des elektrischen Energieverteilungssystems (10) zu bestimmen, einschließlich eines Nulldrehmoments, eines Massestroms, eines Gegenstromdrehmoments, eines Gegenstroms und eines Phasendrehmoments und eines Phasorstroms für jede der drei Phasen;

Eine Masseelement-Logikschaltung (202), welche konfiguriert ist, um einen ersten Fehlerzustand in einer Richtung der ersten Seite (18x) anzuzeigen, wenn mindestens entweder das Nulldrehmoment, das Gegenmoment oder eine Summe der Phasendrehmomente kleiner als Null ist und eine Größe für den Massestrom größer als ein Masse-Überstrom-Grenzwert für die erste Seite (18x) ist, um eine zweite Fehlerbedingung in einer Richtung der zweiten Seite (18y) anzuzeigen, wenn mindestens entweder das Nulldrehmoment, das Gegendrehmoment oder eine Summe der Phasendrehmomente größer als Null ist und die Größe für den Massenstrom größer als der Masse-Überstrom-Grenzwert für die zweite Seite (18y) ist, und eine Null-Fehlerbedingung angezeigt wird, wenn weder die erste noch die zweite Fehlerbedingung gegeben ist;

Eine Negativelementlogikschaltung (204), welche konfiguriert ist, um eine ersten Fehlerzustand, wenn das Gegenstromdrehmoment kleiner als Null ist und die Größe für den Gegenstrom größer als ein negativer Überstrom-Grenzwert für die erste Seite (18x) ist, die zweite Fehlerbedingung, wenn das Gegenstromdrehmoment größer als Null ist und der Betrag für den Gegenstrom größer als ein negativer Überstrom-Grenzwert für die zweite Seite (18y) anzuzeigen, eine Null-Fehlerbedingung angezeigt wird, wenn weder die erste noch die zweite Fehlerbedingung gegeben ist;

und eine Phasenelementlogikschaltung (206), um den ersten Fehlerzustand anzuzeigen, wenn irgendeines der Dreiphasen-Drehmomente kleiner als Null ist und ein Maximalwert der Größe des Phasorstroms für irgendeine der drei Phasen größer als ein Überstrom-Phasenschwellenwert für die erste Seite (18x) ist, die zweite Fehlerbedingung, wenn eines der drei Phasenmomente größer als Null ist und der Höchstwert der Größe des Phasorstroms für eine der drei Phasen größer als ein Überstrom-Phasenschwellwert für die zweite Seite ist (18y eine Null-Fehlerbedingung angezeigt wird, wenn weder die erste noch die zweite Fehlerbedingung gegeben ist.

5. Richtungselement nach Anspruch 4, wobei die Phasenelementlogikschaltung (206) ferner konfiguriert ist, um den ersten Fehlerzustand anzuzeigen, wenn eine Summe der Phasendrehmomente für jede der Phasen kleiner als Null ist oder wenn der maximale Wert der Größe für irgendeinen der drei Phasenströme größer als der Überstrom-Phasenschwellenwert für die erste Seite (18x) ist und ein maximaler Wert irgendeines Phasendrehmoments kleiner oder gleich Null ist.

**6.** Richtungselement nach Anspruch 5, wobei die Phasenelementlogikschaltung (206) ferner konfiguriert ist, um den zweiten Fehlerzustand anzuzeigen, wenn die Summe der Phasendrehmomente gleich oder größer als Null ist oder wenn der maximale Wert der Größe für irgendeinen der drei Phasorströme größer als ein Überstrom-Phasenschwellenwert für die zweite Seite (18y) ist und der minimale Wert irgendeines Phasendrehmoments gleich oder größer als Null ist.

**Revendications**

**1.** Procédé de détection de défaut et de détermination de direction dans un système de distribution d'énergie électrique triphasé (10) incluant un réseau présentant une première source (12) sur un premier côté (18x) du réseau et une seconde source (14) sur le second côté (18y) du réseau, le procédé comprenant :

la mesure d'un courant et d'une tension pour chacune des trois phases de puissance à un emplacement situé entre les premier et second côtés (18x, 18y) pour déterminer un état de fonctionnement du système de distribution d'énergie électrique (10) incluant un couple homopolaire, un courant à la terre, un couple inverse, un courant inverse, et un couple de phase et un courant de phaseur pour chacune des trois phases ;

l'évaluation de l'état de fonctionnement en utilisant un algorithme logique d'élément de masse (202) pour indiquer une première condition de défaut dans une direction du premier côté (18x) quand au moins l'un parmi la séquence de couple nul, le couple inverse ou une somme des couples de phase est inférieur à zéro et qu'une grandeur pour le courant à la terre est supérieure à une valeur seuil de masse de surintensité pour le premier côté (18x), une seconde condition de défaut dans une direction du second côté (18y) quand au moins l'un parmi la séquence de couple nul, le couple inverse ou la somme des couples de phase est supérieur à zéro et que la grandeur pour le courant à la terre est supérieure à la valeur seuil de masse de surintensité pour le second côté (18y), et une condition d'absence de défaut quand ni la première ni la seconde condition de défaut n'est indiquée ;

l'évaluation de l'état de fonctionnement en utilisant un algorithme logique d'élément négatif (204) pour indiquer la première condition de défaut quand le couple inverse est inférieur à zéro et que la grandeur pour le courant inverse est supérieure à une valeur seuil négative de surintensité pour le premier côté (18x), la seconde condition de défaut quand le couple inverse est supérieur à zéro et que la grandeur pour le courant inverse est supérieure à une valeur seuil négative de surintensité pour le second côté (18y), et la condition d'absence de défaut quand ni la première ni la seconde condition de défaut n'est indiquée ; et

l'évaluation de l'état de fonctionnement en utilisant un algorithme logique d'élément de phase (206) pour indiquer la première condition de défaut quand l'un quelconque des trois couples de phase est inférieur à zéro et qu'une valeur maximale de la grandeur du courant de phaseur pour l'une quelconque des trois phases est supérieure à une valeur seuil de phase de surintensité pour le premier côté (18x), la seconde condition de défaut quand l'un quelconque des couples de phase est supérieur à zéro et que la valeur maximale de la grandeur du courant de phaseur pour l'une quelconque des trois phases est supérieure à une valeur seuil de phase de surintensité pour le second côté (18y), et la condition d'absence de défaut quand ni la première ni la seconde condition de défaut n'est indiquée.

**2.** Procédé de détection de défaut et de détermination de direction selon la revendication 1, comprenant en outre l'évaluation de l'état de fonctionnement en utilisant l'algorithme logique d'élément de phase (206) pour indiquer la première condition de défaut quand une somme des couples de phase pour chacune des phases est inférieure à zéro ou quand la valeur maximale de la grandeur pour l'un quelconque des trois courants de phaseur est supérieure à la valeur seuil de phase de surintensité pour le premier côté (18x) et qu'une valeur maximale de n'importe quelle valeur de couple de phase est inférieure ou égale à zéro.

**3.** Procédé de détection de défaut et de détermination de direction selon la revendication 2, comprenant en outre l'évaluation de l'état de fonctionnement en utilisant l'algorithme logique d'élément de phase (206) pour indiquer la seconde condition de défaut quand la somme des couples de phase pour chacune des phases est supérieure ou égale à zéro ou quand la valeur maximale de la grandeur pour l'un quelconque des trois courants de phaseur est supérieure à une valeur seuil de phase de surintensité pour le second côté (18y) et qu'une valeur minimale de n'importe quelle valeur de couple de phase est supérieure ou égale à zéro.

**4.** Élément directionnel (22) pour la détection d'un défaut et la détermination d'une direction dans un système de distribution d'énergie électrique triphasé (10) incluant un réseau présentant une première source sur un premier côté (18x) du réseau et une seconde source sur un second côté (18y) du réseau, l'élément directionnel servant à évaluer l'état de fonctionnement du système de distribution d'énergie électrique (10) et comprenant :

un élément de capteur configuré pour mesurer un courant et une tension pour chacune des trois phases de puissance à un emplacement situé entre les premier et second côtés (18x, 18y) et déterminer un état de fonctionnement du système de distribution d'énergie électrique (10) incluant un couple homopolaire, un courant à la terre, un couple inverse, un courant inverse, et un couple de phase et un courant de phaseur pour chacune des trois phases ;

un circuit logique d'élément de masse (202) configuré pour indiquer une première condition de défaut dans une direction du premier côté (18x) quand au moins l'un parmi le couple homopolaire, le couple inverse ou une somme des couples de phase est inférieur à zéro et qu'une grandeur pour le courant à la terre est supérieure à une valeur seuil de masse de surintensité pour le premier côté (18x), une seconde condition de défaut dans une direction du second côté (18y) quand au moins l'un parmi le couple homopolaire, le couple inverse ou une somme des couples de phase est supérieur à zéro et que la grandeur pour le courant à la terre est supérieure à la valeur seuil de masse de surintensité pour le second côté (18y), et une condition d'absence de défaut quand ni la première ni la seconde condition de défaut n'est indiquée ;

un circuit logique d'élément négatif (204) configuré pour indiquer la première condition de défaut quand le couple inverse est inférieur à zéro et que la grandeur pour le courant inverse est supérieure à une valeur seuil négative de surintensité pour le premier côté (18x), la seconde condition de défaut quand le couple inverse est supérieur à zéro et que la grandeur pour le courant inverse est supérieure à une valeur seuil négative de surintensité pour le second côté (18y), et la condition d'absence de défaut quand ni la première ni la seconde condition de défaut n'est indiquée ; et

un circuit logique d'élément de phase (206) pour indiquer la première condition de défaut quand l'un quelconque des trois couples de phase est inférieur à zéro et qu'une valeur maximale de la grandeur du courant de phaseur pour l'une quelconque des trois phases est supérieure à une valeur seuil de phase de surintensité pour le premier côté (18x), la seconde condition de défaut quand l'un quelconque des trois couples de phase est supérieur à zéro et que la valeur maximale de la grandeur du courant de phaseur pour l'une quelconque des trois phases est supérieure à une valeur seuil de phase de surintensité pour le second côté (18y), et la condition d'absence de défaut quand ni la première ni la seconde condition de défaut n'est indiquée.

5. Elément directionnel selon la revendication 4, dans lequel le circuit logique d'élément de phase (206) est configuré en outre pour indiquer la première condition de défaut quand une somme des couples de phase pour chacune des phases est inférieure à zéro ou quand la valeur maximale de la grandeur pour l'un quelconque des trois courants de phaseur est supérieure à la valeur seuil de phase de surintensité pour le premier côté (18x) et qu'une valeur maximale de n'importe quel couple de phase est inférieure ou égale à zéro.

6. Elément directionnel selon la revendication 5, dans lequel le circuit logique d'élément de phase (206) est configuré en outre pour indiquer la seconde condition de défaut quand la somme des couples de phase est supérieure ou égale à zéro ou quand la valeur maximale de la grandeur pour l'un quelconque des trois courants de phaseur est supérieure à une valeur seuil de phase de surintensité pour le second côté (18y) et que la valeur minimale de n'importe quel couple de phase est supérieure ou égale à zéro.

FIG. 1

FIG. 2

Start

T > 0 : Current flowing from X to Y
T < 0 : Current flowing from Y to X

208

200

$V_0 \geq Z_\beta V_n$ & $I_0 \geq Z_\alpha \max\{I_A, I_B, I_C\}$

Yes

No

ungrounded or $V_2 \leq N_\beta V_n$

No

$T_{zero} + T_{neg} \geq 0$

Yes

No

Yes

$T_{zero} \geq 0$

Yes

No

202 (Ground Element Logic)

$V_2 \geq N_\beta V_n$

Yes

No

$T_{neg} \geq 0$

Yes

No

$T_A + T_B + T_C \geq 0$

Yes

No

212

$3I_0 > \tau_g^Y$

Yes

No

No

$3I_0 > \tau_g^X$

Yes

210

FIG - 3A

To Fig - 3B

13

EP 3 227 697 B1

*FIG - 3B*

From Fig - 3A

200

204
( Negative
Element
Logic )

214

$V_2 \geq N_\beta V_n$

Yes

$T_{neg} \geq 0$

Yes

No

No

$T_A + T_B + T_C \geq 0$

Yes

No

218

$I_2 > \tau_n^Y$

No

Yes

216

$I_2 > \tau_n^X$

No

Yes

To Fig - 3C

Fault on Y

Fault on X

EP 3 227 697 B1

$$\text{FIG - 3C}$$

EP 3 227 697 B1

**From Fig - 3C**

200

Phase Element Logic 206

$I_A > \tau_{ph}^y$ & $T_{Amin} \geq 0$ & $T_{Amax} \geq 0$ — No → $I_A > \tau_{ph}^x$ & $T_{Amin} \leq 0$ & $T_{Amax} \leq 0$ — Yes → $T_{rec} = T_{rec} + TA$

Yes ↓ ... No

226

$I_B > \tau_{ph}^y$ & $T_{Bmin} \geq 0$ & $T_{Bmax} \geq 0$ — No → $I_B > \tau_{ph}^x$ & $T_{Bmin} \leq 0$ & $T_{Bmax} \leq 0$ — Yes → $T_{rec} = T_{rec} + TB$

Yes ↓ ... No

228

$I_C > \tau_{ph}^y$ & $T_{Cmin} \geq 0$ & $T_{Cmax} \geq 0$ — No → $I_C > \tau_{ph}^x$ & $T_{Cmin} \leq 0$ & $T_{Cmax} \leq 0$ — Yes → $T_{rec} = T_{rec} + TC$

Yes ↓ ... No

230

**To Fig - 3E**

*FIG - 3D*

*FIG - 3E*

EP 3 227 697 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 62085961
- US 14956125 B
- KR 20140056964
- US 5349490 A